## Europäisches Patentamt
## European Patent Office
## Office européen des brevets

(19)

(11) Veröffentlichungsnummer: **0 222 738**
**A2**

# (12) EUROPÄISCHE PATENTANMELDUNG

(21) Anmeldenummer: **86890316.2**

(22) Anmeldetag: **13.11.86**

(51) Int. Cl.⁴: **G 03 F 1/00**

(30) Priorität: **13.11.85 AT 3312/85**

(43) Veröffentlichungstag der Anmeldung:
**20.05.87 Patentblatt 87/21**

(84) Benannte Vertragsstaaten:
**AT BE DE FR GB IT NL SE**

(71) Anmelder: **IMS Ionen Mikrofabrikations Systeme
Gesellschaft m.b.H.
Schreygasse 3
A-1020 Wien(AT)**

(72) Erfinder: **Löschner, Hans, Dr.
Vegagasse 6/2
A-1190 Wien(AT)**

(72) Erfinder: **Stengl, Gerhard, Dr.
Hammergasse 11
A-9500 Villach Kärnten(AT)**

(74) Vertreter: **Krause, Ernst, Dipl.-Ing. et al,
Dipl.-Ing. Krause, Ernst Dipl. Ing. Casati, Wilhelm
Patentanwälte Amerlingstrasse 8
A-1061 Wien(AT)**

(54) Verfahren zur Herstellung einer Transmissionsmaske.

(57) Die Erfindung betrifft Verfahren zur Herstellung von Transmissionsmasken, die bei der Strukturierung von Halbleitersubstraten Verwendung finden können, in additiver oder subtraktiver Weise durch zweimaliges galvanisches Aufbauen von Schichten, von welchen eine die Maskenstruktur und die andere ein die Öffnungen in der Maskenstruktur überspannende Gitterstruktur ist. Die Stärke der Struktur ist dabei (innerhalb technologisch bedingter Grenzen) frei wählbar selbstjustierend. Ziel ist die Erstellung einer Transmissionsmaske mit über die Maskenfläche konstanter, effektiver Dicke.

EP 0 222 738 A2

## Verfahren zur Herstellung einer Transmissionsmaske

Durch elektromagnetische Strahlung oder mittels Teilchenstrahlung können Strukturen einer Transmissionsmaske maßgetreu auf ein Substrat abgebildet werden. Transmissionsmasken können vor allem bei der Herstellung von Submikrometerstrukturen mit 1 : 1 abbildender Elektronen- oder Ionen-Schattenbelichtung oder mit verkleinernder Elektronen- oder Ionenprojektion mit relativ einfachen Maßnahmen weitgehend verzerrungsfrei betrieben werden. Die Maske besteht dabei aus einer Folie mit Strukturflächen, die über die gesamte Maskenfläche möglichst konstante Dicke aufweisen, sowie aus Öffnungen in dieser Folie. Zur Erhöhung der Stabilität der gesamten Maskenstruktur und somit zur Gewährleistung der maßgetreuen Übertragung werden die Öffnungen in der Maskenfolie von einer Gitterstruktur durchzogen. Bei genügend geringer Stegbreite werden die Stege durch das Abbildungsmedium überstrahlt, so daß auf dem zu bearbeitenden Substrat eine kontinuierliche Strukturierung, welche dem vorgegebenen Maskendesign entspricht, erreicht wird. Für breitere Stege kann das Verfahren der sogenannten Vierfachbelichtung angewendet werden, bei der das Bild des Abbildungsmediums verschoben wird, um die Gitterstege in der Abbildung nicht mehr aufscheinen zu lassen. Um den Festigkeitsverlust, der durch die vorhandenen Öffnungen bedingt ist, zu kompensieren, wird eine entsprechende Dickenzunahme der Stege des Gitters vorgeschlagen.

Eine Verstärkung der Gitterstege ist insbesondere bei thermischem Vorspannen der Maskenfolie notwendig, um eine ungleichmäßige Dehnung der Maskenfolie und somit eine Verzerrung der zu übertragenden Strukturen, bedingt durch unterschiedliches Dehnvermögen, zu verhindern. Obwohl die Forderung nach einer Verstärkung der Gitterstege eines quadratischen Gitters bekannt ist, um eine Maskenfolie in einen Maskenrahmen mit höherem thermischen Ausdehnungskoeffizienten als die Maskenfolie einspannen zu können, sind Verfahren zur Herstellung derartiger Maskenfolien nicht bekannt geworden.

Die Erfindung betrifft demgemäß Verfahren zur Herstellung einer Transmissionsmaske zur Verwendung bei der Strukturierung von Substraten, insbes. von Halbleitersubstraten, bei der für ein Abbildungsmedium durchlässige Gebiete der Transmissionsmaske auf das Substrat abgebildet werden, wobei die für das Abbildungsmedium durchlässigen Gebiete der Transmissionsmaske eine Gitterstruktur mit gegenüber der Maskenfolie verstärkten Stegen aufweisen und sieht vor, daß erfindungsgemäß das Gitter regulär über die gesamte Maskenfläche abgebildet wird, daß das Gitter hierauf nur in dem von den Öffnungen der abzubildenden Struktur eingenommenen Bereich in selbstjustierender (beliebiger) Dicke hergestellt wird, wobei gegebenenfalls Gitterstege den Rand der Struktur überdeckend ausgebildet werden. Das erfindungsgemäße Verfahren erlaubt es, die Gitterstruktur so zu gestalten, daß über die gesamte Maskenfläche die effektive Dicke der Folie auch in den Gitterbereichen im wesentlichen konstant ist. Dadurch wird es möglich, Gitterstrukturen im Bereich von 1 $\mu$m und darunter zu erzeugen. Benötigt werden bei beiden Ausführungsformen jeweils nur je eine Vorlage der abzubildenden Maskenstruktur und eine Vorlage für eine reguläre Gitterstruktur, die gleichmäßig auf die gesamte Maskenfläche abgebildet wird. Wesentlich für die Erfindung ist, daß die Struktur des Gitters trotz regulärer Abbildung über die gesamte Maskenfläche auf selbstjustierende Weise nur in den Öffnungen der abzubildenden Struktur hergestellt wird. Eine nach dem erfindungsgemäßen Verfahren hergestellte Maske hat demnach über die gesamte Fläche dieselbe effektive Dicke und kann daher unter der thermischen Belastung durch elektromagnetische Strahlung oder durch Teilchenstrahlung mit relativ einfachen Maßnahmen weitgehend verzerrungsfrei betrieben werden. Das erfindungsgemäße Verfahren zur Herstellung von Transmissionsmasken mit selbstjustiert verstärkten Gitterstegen in obigem Sinne, kann bei allen wichtigen Fertigungsverfahren von freitragenden Transmissionsmasken angewendet werden, z.B. bei der galvanischen Aufbaumethode, bei der Herstellung von dünnen Siliziumfolien über hochdotierte Gebiete mit verringerter Ätzrate und bei der Herstellung von dünnen Folien etwa aus Siliziumnitrid mit einer Silizium-Ringhalterung.

Eine erste Ausführungsvariante ist dabei dadurch gekennzeichnet, daß auf ein Substrat, dessen Oberfläche für eine galvanische Abscheidung geeignet ist, z.B. ein Siliziumwafer oder eine Glasplatte mit metallischer Kontaktschicht an der Oberfläche, eine bevorzugt organische Resistschicht, z.B. in einer Dicke von 1,5 $\mu$m, aufgebracht wird, daß diese Resistschicht strukturiert wird, z.B. durch UV-Belichtung einer Photomaske und nachfolgender Entwicklung, durch Röntgen- oder Ionenstrahllithographie, bevorzugt scannende Elektronenstrahllithographie, daß auf die strukturfreien, seitlich von der Resistschicht begrenzten Bereiche des Substrates, galvanisch eine Maskenfolie, z.B. aus Nickel, bis zu einer gewählten Dicke, aufgewachsen wird, bevorzugt bis zu einer Dicke, die geringer ist als die Resistdicke, daß auf die freie Oberfläche der galvanisch aufgewachsenen Maskenfolie, gegebenenfalls unter Freihalten eines Randstreifens zum angrenzenden Resist, eine elektrisch isolierende Schicht, z.B. aus Siliziummonoxid oder Magnesiumoxid, insbes. durch Aufdampfen oder Sputtern, aufgebracht wird, daß der Resist entfernt und solcherart Durchbrechungen in der galvanisch aufgewachsenen Maskenschicht geschaffen werden, die bis zum Substrat reichen, daß die Durchbrechungen in der Maskenfolie durch eine weitere Resistschichte gefüllt werden, die auf das Substrat aufgetragen wird, bis ihr Niveau über dem Substrat höher liegt als das Niveau der elektrisch isolierenden Schicht, daß die freie Oberfläche der das Substrat, samt galvanisch aufgewachsener Maskenfolie und Isolierschicht, bedeckenden Resistschicht mit einer, insbes. regelmäßigen Gitterstruktur, z.B. durch Belichten und Entwickeln, versehen wird, daß die Resistschicht in den von den Gitterstegen eingenommenen Bereichen entfernt wird, daß das Substrat, samt der darauf befindlichen, mit der Isolierschicht bedeckten Maskenfolie und dem in Form einzelner Blöcke verbliebenen Resist einem (zweiten) Galvanikprozeß unterworfen wird, wobei zwischen den Blöcken eine metallische Schicht bis zu einer frei gewählten Dicke in jenen Bereichen aufgewachsen wird, deren Grund elektrisch leitend ist, die mit der Isolierschicht bedeckten Bereiche der Maskenfolie sowie die von den Blöcken eingenommenen Bereiche auf der Isolierschicht und auf der freien Oberfläche des Substrates im Bereich der Durchbrechungen der Maskenfolie jedoch frei von galvanisch aufgebautem Material bleiben, wobei das galvanische Aufwachsen des Materials solange fortgesetzt wird, bis die freie Oberfläche der aufgewachsenen Gitterstruktur höher liegt als die freie Oberfläche der Maskenfolie, bevorzugt bis die freie Oberfläche der Gitterstruktur das Niveau der freien Oberfläche der Resistblöcke erreicht, und daß schließlich die Resistblöcke, z.B. durch chemisches Ablösen oder durch Plasmaveraschen, entfernt werden, worauf die Maskenfolie samt Gitter vom Substrat getrennt wird, z.B. durch Ablösen vom Substrat oder durch Abätzen des Substrates in jenem Bereich, der von der Maskenfolie eingenommen wird, wobei das Substrat als ring- bzw. rahmenartige Halterung der Maskenfolie verbleibt.

Gemäß einer zweiten Ausführungsvariante ist vorgesehen, daß auf ein Substrat, z.B. einem Si-Wafer, in einer Schicht oder in mehreren Schichten aus voneinander verschiedenen Materialien ein Belag aufgebracht wird, der gegen Ätzlösungen widerstandsfähiger ist als das Material des Substrates, daß der Belag in Bereichen seiner Oberfläche mit einer Maskierung aus einem Resist abgedeckt wird, daß der Belag samt darauf befindlicher Maskierung reaktiv geätzt wird, um in den Bereichen, die nicht vom Resist bedeckt sind, Belagsmaterial zu entfernen und Einsenkungen zu bilden, deren Boden höher liegt als die Trennebene zwischen Belag und Substrat, daß der die Maskierung bildende Resist von den erhabenen Stellen des Belages entfernt wird und die Böden der Einsenkungen abgedeckt werden, z.B. mit einem Photolack oder einer aufgedampften Schicht, daß auf die freie Oberfläche der erhabenen Bereiche des Belages und die freie Oberfläche der Abdeckung der Böden der Einsenkungen eine weitere Maskierungsschicht aufgebracht und als Gitter strukturiert wird, daß die Belagschicht in jenen Bereichen, bevorzugt durch Ätzen, entfernt wird, in welchen die Oberfläche der Belagschicht frei liegt und gegebenenfalls auch das Substrat ausgehend von den freigelegten Bereichen angeätzt wird, daß sodann, bevorzugt durch Plasmaätzen oder durch einen reaktiven Ätzvorgang, die erhabenen Gebiete des Belages und auch die demgegenüber eingesenkten Gebiete des Belages freigelegt werden, worauf gegebenenfalls das Substrat unter Belassung eines Ringes im Randbereich der Belagschicht entfernt wird.

Insbes. bei Anwendung der ersten Ausführungsvariante des erfindungsgemäßen Verfahrens können Stege der Gitterstruktur den Randbereich der abzubildenden Struktur übergreifen und somit die Verbindung zwischen Gitter und Maskenstruktur verbessern. Die Dicke der abzubildenden Struktur und die Dicke (Wabenhöhe) der Gitterstruktur sind voneinänder unabhängig und können (innerhalb technologisch bedingter Grenzen) beliebig gewählt werden. Insbesondere kann bei Anwendung des erfindungsgemäßen Verfahrens in jeder der beiden vorerwähnten Ausführungsvarianten die Dicke der Gitterstrukturen derart erhöht werden, daß - bedingt durch die Gitterung - durch die Öffnungen kein wesentlicher Festigkeitsverlust gegenüber der nichtgegitterten Folie auftritt, sodaß die effektive Dicke der Gitterbereiche der Dicke der ungegitterten Strukturflächenbereiche in etwa gleichkommt.

Durch Anwendung des erfindungsgemäßen Verfahren in beiden Ausführungsvarianten kann daher auf selbstjustierende Weise eine Maskenfolie mit verstärkten Gitterstegen hergestellt werden. Dabei wird "Selbstjustierung" in dem Sinne verstanden, daß die Maskenstrukturbereiche - die sogenannten Designgebiete - die kein Gitter aufweisen, in situ, die Maskierung für die Gitterbereiche darstellen, sodaß beim zweiten Lithographieprozeß über die gesamte Maskenfläche, regelmäßige Gitterstrukturen im entsprechenden Resist hergestellt werden können. Durch die Selbstjustierung entstehen nur in den Öffnungsbereichen der Maskenfolie Gitterstrukturen, wobei deren Dicke (Wabenhöhe) in dem durch die Reststärke technologisch vorgegebenen Bereich einstellbar ist, d.h. die Dicke der Gitterstruktur ist nur durch die Reststärke begrenzt.

Der Umstand, daß unter Anwendung des erfindungsgemäßen Verfahrens eine Struktur sehr einfachen Aufbaus - etwa ein Gitter mit nur einer Gitterkonstanten - für die Herstellung der lokalen Gitterstrukturen übertragen werden kann, läßt die Anwendung einfacher und gut kontrollierbarer Prozesse mit Submikrometer--Auflösung zu, wie etwa die Laserholographie. Auch können gerade derartige regelmäßige Gitterstrukturen effektiv mit verkleinernden optischen Projektionsgeräten (optischen Wafer Steppern) über große Bereiche mit einer geometrischen Auflösung bis in den Submikrometerbereich (bei ebenen Resistsubstraten) übertragen werden. Eine Verbesserung läßt die verkleinernde Ionenprojektion erwarten.

Bei einem sowohl die Gitterstruktur als auch die Maskenstruktur galvanisch aufbauenden Verfahrens kann mit dem gleichen Ziel der Selbstjustierung vorgesehen werden, daß die Resiststrukturen an ihrer freien Oberfläche breiter ausgeführt werden als in dem von der freien Oberfläche bis zum Substrat reichenden Bereich, bevorzugt dadurch, daß die freie Oberfläche der Resistschicht, nach dem Auftragen auf das Substrat und vor der Belichtung des Resists einer Härtung (Desensibilisierung), z.B. durch Chlorbenzol, unterzogen wird, sodaß bei der nachfolgenden Entwicklung zufolge der vorhandenen Resistoberflächenbereiche von geringer Löslichkeit, die Resiststrukturen eine verbreiterte (dachartige) freie Oberfläche aufweisen.

Die Verbreiterung an der Oberfläche kann auch durch Anwendung eines aus drei Lagen unterschiedlicher Eigenschaften gebildeten Resists erfolgen. Dabei wird zunächst eine relativ dicke Grundschicht aufgetragen, die dann durch zwei aufeinanderfolgend aufgetragene dünne Schichten abgedeckt wird. Die oberste Schicht besteht dabei aus einem Material, das optisch oder gegen Elektronenstrahlen empfindlich ist. In die oberste Lage wird daher die Struktur durch Elektronenstrahl- oder optische Lithographie übertragen und dann in die mittlere Schichte, etwa durch reaktives Ätzen. Von der mittleren Schicht kann dann die weitere Übertragung gesteuert in die relativ dicke Grundschicht erfolgen, wobei die strukturierte Mittelschicht für diese Übertragung die Maskierung darstellt. Bei dieser Übertragung kann dann eine seitliche Verbreiterung durch Wahl geeigneter Ätzparameter erfol-

gen, sodaß die obere bzw. mittlere Schicht, welche die Maske für den Ätzvorgang gebildet hat, gegenüber der Grundschicht vorsteht. Auf diese Weise kommt es dann zur Ausbildung des Daches an der freien Oberfläche. Eine weitere Möglichkeit, die Resiststruktur zu verbreitern, besteht darin, daß zunächst eine dickere Resistschicht aufgetragen wird und die Struktur dann durch Elektronenstrahllithographie erzeugt wird, wobei durch die Streuung der Elektronenstrahlen nach der Seite, beim nachfolgenden Entwickeln dann in der Resistschicht eine Verbreiterung im oberen Teil der Schicht erzielt werden kann.

Der breitere Bereich an der Oberfläche der Resiststrukturen stellt sicher, daß beim folgenden Aufbringen der elektrisch isolierenden Schicht durch Aufdampfen oder Sputtern, die Randstreifen der bereits vorhandenen galvanisch aufgewachsenen Schicht im Schatten der Verbreiterung liegen und damit frei von isolierender Schicht gehalten werden. Der von Isoliermaterial freie Randstreifen ermöglicht es, daß beim galvanischen Aufwachsen des Gitters, Gitterstege auch vom Rand der abzubildenden Struktur aufwachsen, wodurch dann eine besonders gute Verbindung zwischen Gitter und Struktur erzielt wird.

In Weiterbildung der zweiten, ein subtraktives (Abbau-)Verfahren für die Herstellung des Gitters vorsehenden Ausführungsvariante des erfindungsgemäßen Verfahrens kann vorgesehen werden, daß die die Böden der Einsenkungen des Belages abdeckende Schicht auch die erhabenen Gebiete des Belages abdeckend aufgebracht wird und hernach die erhabenen Gebiete durch Abtragen der Schicht bis auf ein unter dem Niveau der erhabenen Gebiete gelegenes Niveau freigelegt werden, die Böden der Einsenkungen des Belages jedoch von der Schicht bedeckt belassen werden. Die abdeckende Schicht kann auf die vorgenannte Art besonders einfach hergestellt werden.

Die Erfindung wird nachstehend anhand der Zeichnung beispielsweise näher erläutert. Es zeigen,

Fig. 1 in Draufsicht einen Ausschnitt aus einer Transmissionsmaske, hergestellt nach der zweiten Ausführungsform des erfindungsgemäßen Verfahrens, d.h. nach dem subtraktiven Vorgang,

Fig. 2 in schaubildlicher Darstellung die Transmissionsmaske gemäß Fig. 1,

Fig. 3 in vergrößertem Maßstab einen Eckbereich aus Fig. 2, die

Fig. 4 bis 11 jeweils im Querschnitt verschiedene Stadien bei der Herstellung einer Transmissionsmaske nach dem additiven Verfahren, und die

Fig. 12 bis 19 ebenfalls jeweils im Querschnitt verschiedene Stadien bei der Herstellung einer Transmissionsmaske nach dem subtraktiven Verfahren.

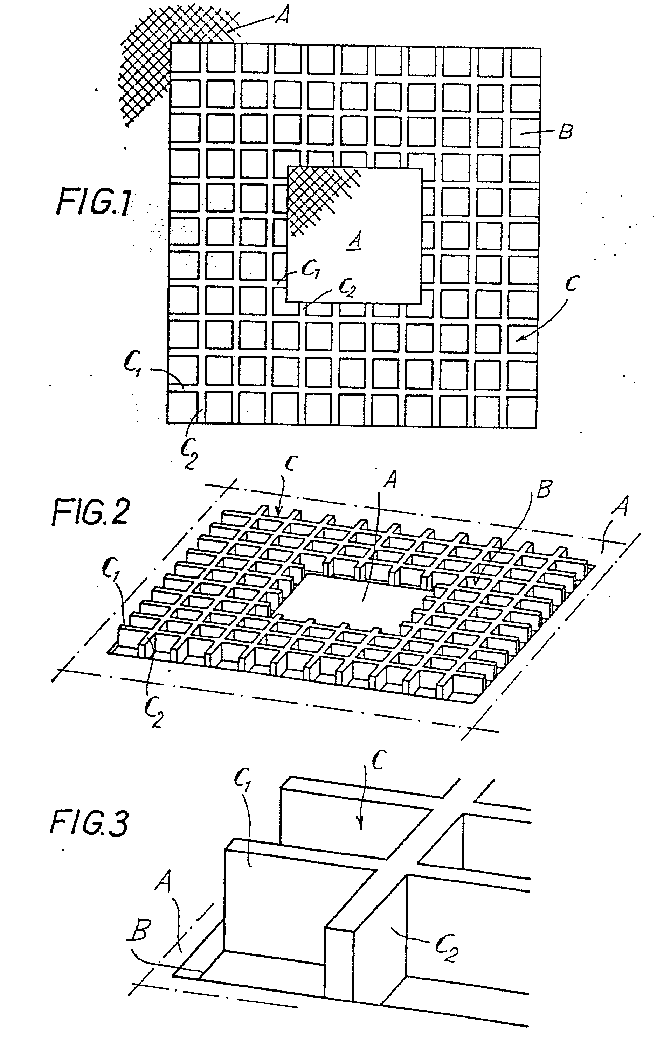

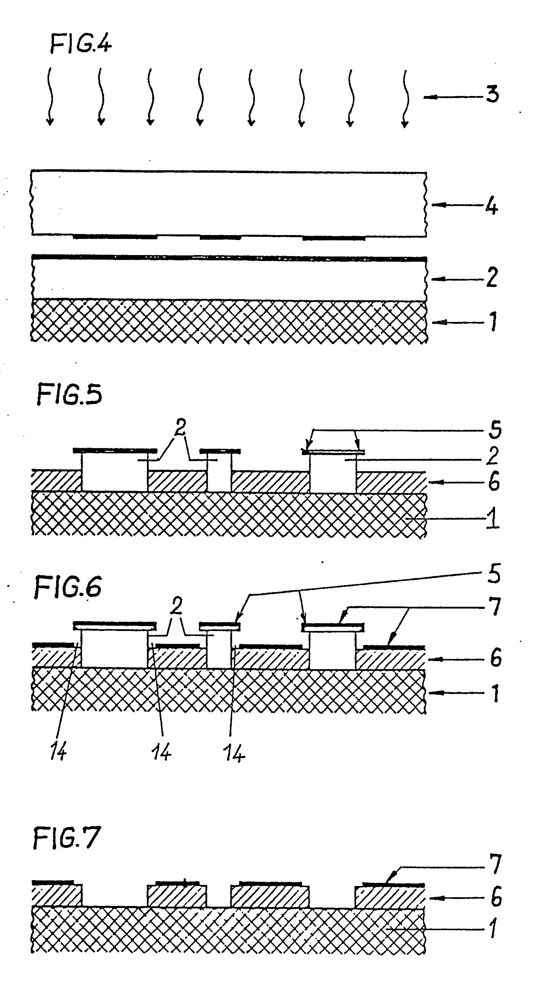

In den Fig. 1 - 3 ist mit A ausschnittweise das Strukturgebiet einer Maskenfolie bezeichnet. Zwischen den Strukturgebieten bestehen Öffnungen B, die durch ein Gitter C überspannt sind. Die den Strukturrändern benachbarten Gitterstege C1, C2 sind mit den Rändern der Struktur A fest verbunden. In den Fig. 4 bis 11 sind die Verfahrensschritte zur Herstellung der Transmissionsmaske mit Gitterstruktur für ein Verfahren, bei dem der Aufbau der Strukturbereiche der Transmissionsmaske und der Gitterbereiche in einem additiven Vorgang erfolgt, veranschaulicht.

Auf ein Substrat 1, dessen Oberfläche für eine galvanische Abscheidung geeignet ist, wird eine Resistschicht 2 aufgebracht. Als Substrat 1 kann dabei ein Si-Wafer oder auch eine Glasplatte mit metallischer Ankontaktierschicht verwendet werden. Die Dicke der bevorzugt aus einem organischen Material bestehenden Resistschicht 2 kann 1,5 µm betragen. In die Resistschicht 2 werden über eine Photomaske 4 Strukturen übertragen. Die Übertragung der Fotomaske 4 kann dabei beispielsweise durch eine UV-Belichtung, deren Strahlen in Fig. 4 mit 3 bezeichnet sind, erfolgen. Durch geeignete Entwicklung der Resistschicht 2 werden die Strukturen ausgebildet. Die Strukturierung der Resistschicht 2 kann auch alternativ auf lithographischem Wege erfolgen, beispielsweise durch Röntgen- oder Ionenstrahllithographie, wobei vor allem das Verfahren der scannenden Elektronenstrahllithographie bevorzugt wird. Die Resistschicht 2 wird dann in den stärker belichteten Teilen bis auf die Oberfläche des Substrates 1 abgetragen oder abgebaut, sodaß auf dem Substrat 1 strukturfreie, seitlich von der Resistschicht 2 begrenzte Bereiche entstehen, auf die galvanisch eine Maskenfolie 6, bevorzugt aus einem
Nickelbad, aufgewachsen wird. Das Material der aufgewachsenen
Maskenfolie 6 soll bevorzugt einen thermischen Ausdehnungskoeffizienten besitzen, der jenem des Materials des Substrates 1
nahekommt. Die Dicke der Maskenfolie 6 ist dabei frei wählbar,
jedoch ist die Dicke der Maskenfolie 6 geringer als die Dicke des
Resists 2, der im 1. Verfahrensschritt (Fig. 4) auf das Substrat 1
aufgebracht wurde.

Fig. 5 zeigt dabei die Situation, wie sie sich nach dem
galvanischen Aufwachsen der Maskenschicht 6 darstellt. Wie aus
Fig. 5 weiters ersichtlich ist, ist die Struktur des Resists 2 an
ihrer vom Substrat 1 abliegenden Oberfläche verbreitert. Die
Verbreiterung ist in Fig. 5 mit 5 bezeichnet. Die Verbreiterung 5
kann dabei auf unterschiedlichem Weg erreicht werden. So kann
etwa eine Chlorbenzolbehandlung der freien Oberfläche der auf
das Substrat 1 im ersten Verfahrensschritt aufgetragenen Resistschicht 2 erfolgen. Durch die Chlorbenzolbehandlung wird die
freie Oberfläche der Resistschicht desensibilisiert und bei der
nachfolgenden Entwicklung entstehen zufolge der Resistoberfläche
mit geringerer Löslichkeit die entsprechenden Verbreiterungen 5.
Die Verbreiterung der in Fig. 5 mit 5 bezeichneten Struktur des
Resists 2 kann wie bereits beschrieben erfolgen.

Auf die freie Oberfläche der galvanisch aufgewachsenen
Maskenfolie 6 wird nun eine elektrisch isolierende Schicht 7
aufgebracht. Dieses Aufbringen kann beispielsweise durch Aufdampfen oder Sputtern erfolgen. Die Schicht 7 kann dabei z.B.
aus Siliziummonoxid oder Magnesiumoxid bestehen. Beim Aufdampffen bzw. Sputtern wird auch die Oberfläche des Resists 2 und
damit auch der verbreiterte Bereich 5 mit der elektrisch isolierenden Schicht 7 bedeckt.

Fig. 6 zeigt, daß durch die Verbreiterung 5 der Resistschicht 2 verhindert wird, daß der an den Resist 2 anschließende
Randbereich 14 mit isolierender Schicht 7 bedeckt wird. Nunmehr
wird in einem Resistentferner – soferne es sich um eine positive Resistschicht 2 handelt, kann Aceton verwendet werden - der Resist 2 samt darauf befindlicher Isolationsschicht 7 vom Substrat 1 abgehoben (Lift-off). Übrig bleibt, wie dies aus Fig. 7 ersichtlich ist, nach dem Lift-off die galvanisch aufgewachsene strukturierte Maskenfolie 6, auf deren Oberfläche die Isolationsschicht 7 verblieben ist.

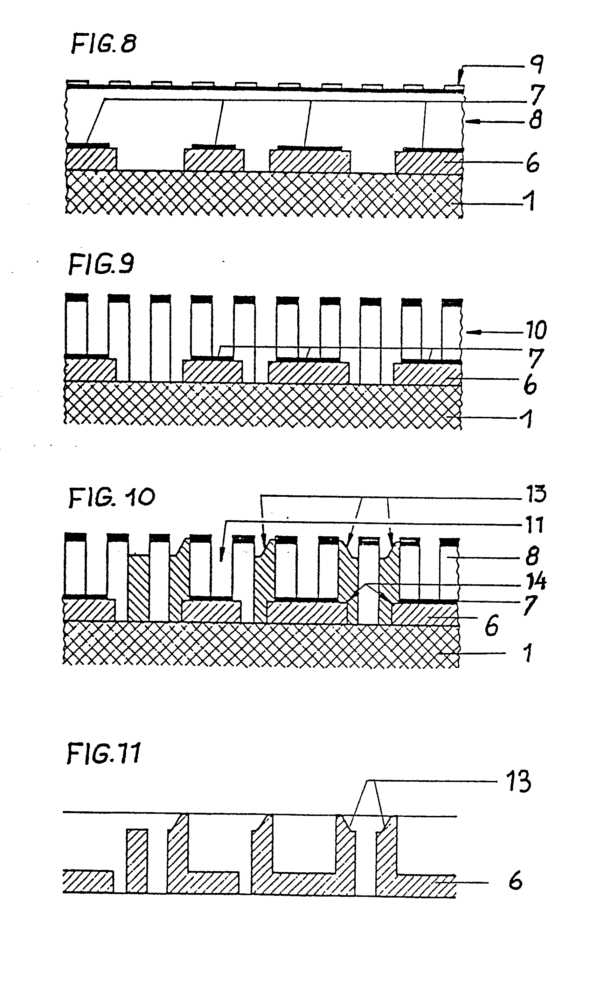

Nun erfolgt die Herstellung des Gitters. Dabei wird zunächst über das Substrat 1, die darauf befindliche Maskenfolie 6 und die Isolierschicht 7 eine dicke Resistschicht 8 aufgebracht, welche einebnend wirkt und die Öffnungen der Maskenfolie 6 ausfüllt. Über den gesamten, von der Maskenfolie 6 auf dem Substrat 1 eingenommenen Bereich wird eine regelmäßige Gitterstruktur entwickelt, wie dies in Fig. 9 mit 10 bezeichnet ist. Die Übertragung des Gitters kann jedoch auch durch einen noch näher zu erläuternden Mehrlagenprozeß erfolgen, um besonders ausgeprägte steile Resistkanten der Gitterstruktur 10 zu erhalten. Bei einem solchen Mehrlagenprozeß führt die Lithographie in der ebenen obersten Resistschicht zu hoch aufgelösten Strukturen 9, welche durch einen reaktiven Ionenätzprozeß oder durch Belichten mit DUV oder mit Röntgenstrahlen, detailgetreu in die darunter befindlichen dickeren Resistschichten übertragen werden. Wird eine einheitliche Resistschicht aufgetragen, so kann diese eine Dicke von ca 5 $\mu$m besitzen; die Erzeugung der Gitterstrukturen kann dann durch Kontakt-Photolithographie erfolgen. Wird ein Dreilagenprozeß angewendet, so wird zunächst eine Grundchicht aufgetragen, auf diese dann eine Zwischenschicht (z.B. 0,3 $\mu$m) aus SiO aufgedampft und die oberste Schicht von einem elektronen- oder photoempfindlichen dünnen Resist (z.B. 0,4 $\mu$m) gebildet. In der obersten Schicht wird ein reguläres Gitter durch Elektronen- oder Photolithographie gebildet und in die SiO-Zwischenschicht z.B. im $CHF_3$-Plasma übertragen. Die Übertragung in die Grundschicht erfolgt dann im $O_2$-Plasma, wobei die strukturierte Zwischenschicht als Maskierung dient. Die Belichtung der regulären Gitterstruktur in der Resistschicht 8 bzw. bei Anwendung der Mehrlagentechnik in der Topschicht 9 kann bei optischer Proximity oder Kontaktlithographie durch zweifaches Belichten mit einer Linienrasterung erfolgen, wobei die zweite Belichtung mit unter 90° zur ersten Belichtung gedrehtem Linienraster erfolgt. Auf diese Weise können quadratische Gitterstrukturen erzeugt werden, wie auch mit Hilfe einer Belichtung mit Laser-Holographie.

Von Vorteil für die Maskenstabilität und für den Transmissionsfaktor der Gitterbereiche ist die Herstellung von Sechseckgittern (Bienenwabenstruktur). Derartige reguläre Gitterstrukturen können mit Hilfe eines optischen Wafer Steppers oder auch mit verkleinernder Ionenprojektion hergestellt werden.

Nach Bildung der Gitterstruktur 10 (Fig. 9) wird das Substrat 1 samt der darauf befindlichen, mit der Isolierschicht 7 (bis auf die freigelassenen Randbereiche) bedeckten Maskenfolie 6 und des in Form einzelner Blöcke 10 verbliebenen Resists 8 einem zweiten Galvanikprozeß unterworfen, wobei zwischen den Blöcken aus dem Resist 8, ausgehend von den elektrisch leitenden Bereichen am Substrat 1 und im Randbereich 14 der Maskenfolie 6 eine metallische Schicht bis zu einer freigewählten Dicke aufgewachsen wird. Die mit der Isolierschicht 7 bedeckten Bereiche der Maskenfolie 6 sowie die von den Blöcken der Resistschicht 8 eingenommenen Bereiche auf der Isolierschicht 7 und auch auf der freien Oberfläche des Substrates 1 im Bereich der Durchbrechungen der Maskenfolie 6 bleiben frei von galvanisch aufgebautem Material. Bei dem vorerwähnten galvanischen Aufbau kann die Schichtdicke des Gitters (Wabenhöhe) unabhängig von der Stärke der Maskenfolie 6 oder, genauer gesagt, von der Stärke des Strukturbereiches der Maskenfolie 6 und somit auch wesentlich dicker als dieser Bereich hergestellt werden. Die Selbstjustierung der Gitterstärke bei Anwendung dieser Technik ergibt eine steuerbare Überlappung zwischen dem Strukturbereich der Maskenfolie 6 und dem Gitter 13, wie dies aus Fig. 10 ersichtlich ist. Dadurch wird im Kantenbereich der Strukturbereiche der Maskenfolie 6 eine erhöhte Stabilität erzielt. Durch eine Verbreiterung 5 des Resists wird an den Rändern der Strukturbereiche ein freier Randbereich 14 erzeugt, auf dem sich die Gitterstege fest verankern.

Im nächsten Schritt wird nun die Resistschicht 8 bzw. der aus mehreren Resistlagen bestehende Bereich 10 durch chemisches Ablösen oder durch Plasmaveraschen entfernt. Schließlich wird die Maskenfolie 6 vom Substrat 1 abgelöst oder, falls das Substrat gleichzeitig als Ringhalterung für die Maskenfolie dienen soll, das Substrat 1 nur im Bereich der Maskenfolie 6 abgeätzt. Das Endprodukt nach dem Entfernen der Resistschicht 8 bzw. der aus mehreren Lagen bestehenden Bereiche 10 ist aus Fig. 11 ersichtlich.

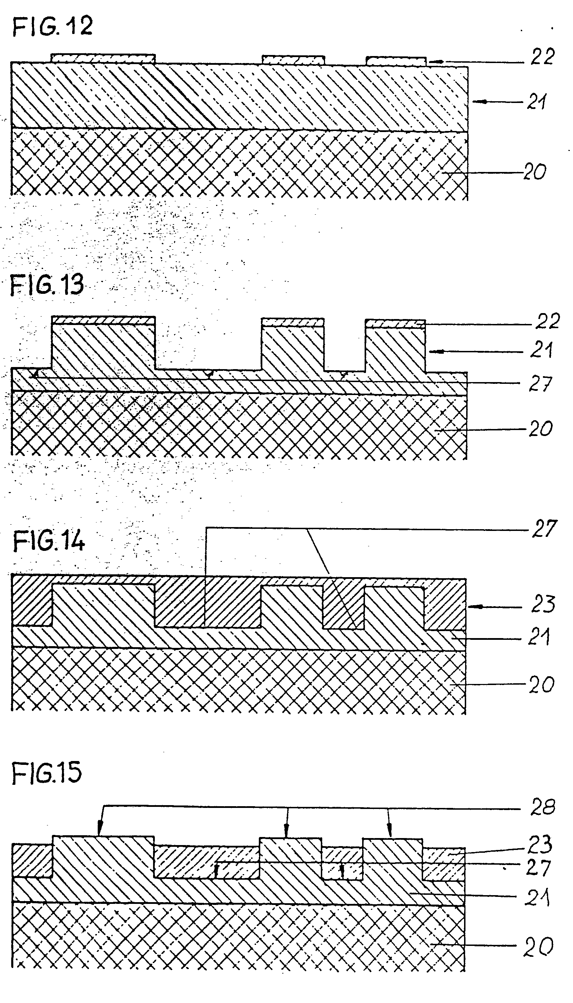

Eine Möglichkeit, die Transmissionsmaske nach einem subtraktiven Verfahren herzustellen, ist schematisch in den Fig. 12 bis 19 veranschaulicht. Als Substrat 20 kann wieder ein Si-Wafer eingesetzt werden. Solche Wafer sind praktisch fehlerfrei und mit sehr guter Oberflächenqualität im Handel erhältlich. Auf das Substrat 20 wird in einer oder auch in mehreren Schichten aus unterschiedlichen Materialien ein Belag 21 aufgebracht, der gegen Ätzlösungen widerstandsfähiger ist als der Werkstoff, aus dem das Substrat 20 besteht. Der Belag 21 kann aus Siliziumnitrid, Bornitrid oder, bei mehrschichtiger Ausbildung, aus aufeinanderfolgenden Schichten aus Siliziumoxid, Siliziumnitrid und abermals Siliziumoxid bestehen. Es ist auch möglich, den Belag durch extrem hohes Dotieren eines dünnen Oberflächenbereiches des Substrats 20 zu erhalten. Der Belag 21 wird sodann in Bereichen seiner Oberfläche mit einer Maskierung aus einem Resist 22 abgedeckt.

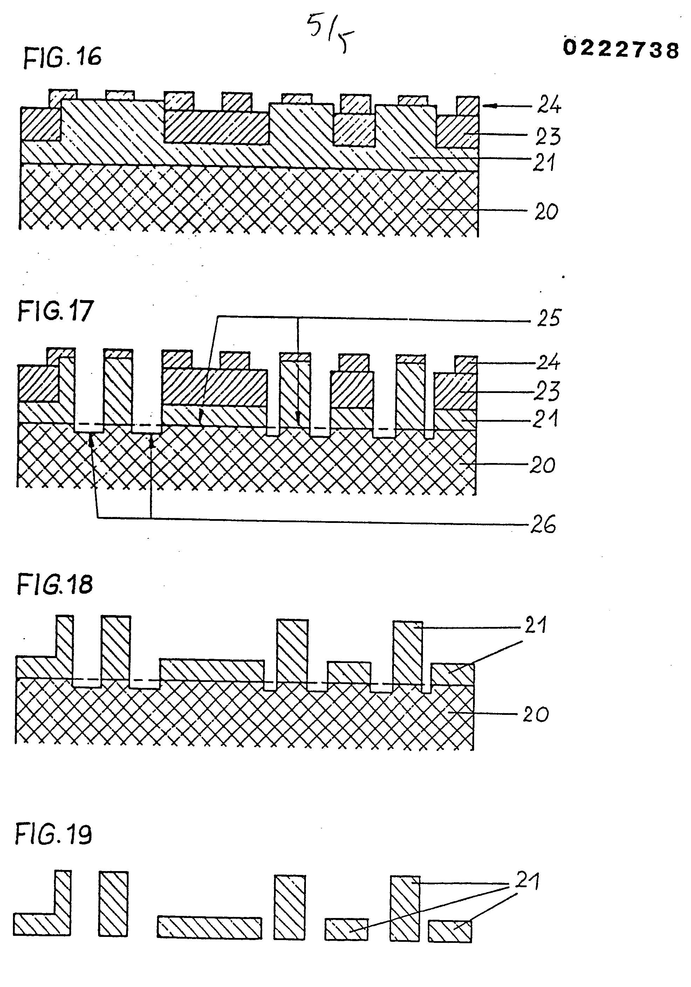

Der Belag 21 samt darauf befindlicher Maskierung aus dem Resist 22 wird reaktiv geätzt, um in den Bereichen, die nicht vom Resist 22 bedeckt sind, das Material des Belages 21 zu entfernen und solcherart Einsenkungen zu bilden, die jedoch nicht bis zur Grenzfläche zwischen dem Belag 21 und dem Substrat 20 reichen (Fig. 13). Der die Maskierung bildende Resist 22 wird von den erhabenen Stellen des Belages 21 entfernt und die Böden 27 der Einsenkungen im Belag 21 werden, beispielsweise mit einem Photolack oder einer aufgedampften Schicht 23, abgedeckt. Die Abdeckung 23 kann, wenn sie aus Photolack besteht, gehärtet werden. Die Abdeckung 23, die die Böden 27 der Einsenkungen des Belages 21 abdeckt, kann auch so dick aufgetragen werden, daß die erhabenen Gebiete des Belages 21 gerade abgedeckt werden. Die erhabenen Gebiete des Belages 21 werden hernach durch Abtragen des zuoberst liegenden Teiles der Abdeckung 23 bis auf ein unter dem Niveau der Deckfläche 28 der erhabenen Gebiete gelegenes Niveau freigelegt. Die Böden 27 der Einsenkungen müssen dabei jedoch von der Abdeckung 23 bedeckt bleiben (Fig. 14 und 15). Auf die freie Oberfläche 28 der erhabenen Bereiche des Belages 21 und die freie Oberfläche der Abdeckung 23 der Böden 27 der Einsenkungen wird eine weitere Maskierungsschicht 24 aufgebracht und als Gitter mittels eines lithographischen Prozesses strukturiert (Fig. 16). Die Belagsschicht 21 wird nunmehr in jenen Bereichen (durch Ätzen) entfernt, in welchen sie freiliegt. Auf diese Weise wird der Belag 21 in den Gitterbereichen strukturiert. In den übrigen Bereichen 25 (Fig. 17) verhindert die Abdeckung 23 bzw. der von der Gitter-Maskierungsschicht 24 bedeckte Bereich des Belages 21 ein Ätzen des Belages 21.

Soferne die Abdeckung 23 als Maskierung für die Strukturierung des Belages 21 nicht ausreichen sollte, kann nach der Bildung der Einsenkungen 22 im Belag 21 (Fig. 13) in den Einsenkungen 27 durch einen Aufdampfprozeß eine verbesserte Maskierung abgeschieden werden. Die dabei gleichzeitig auf den Resist 22 aufgedampfte Schicht wird gemeinsam mit der Resistschicht 22 entfernt (lift-off). In diesem Fall befindet sich dann in den Einsenkungen 27 eine aufgedampfte Schicht, wobei die Abdeckung 23 als Einebnung dient und keine besonderen Maskierungseigenschaften aufweisen muß. Hiebei ist es möglich, die Abdeckung (Fig. 14) überhaupt wegzulassen, soferne die Schärfentiefe des lithographischen Verfahrens für die Gitterübertragung (Fig. 16) ausreichend ist, was insbes. bei verkleinernder Ionenprojektion bei der Gitterherstellung der Fall ist.

Durch ein Überätzen können im Substrat 20 Vertiefungen 26 (Fig. 17) entstehen, die jedoch den Herstellungsprozeß nicht stören.

Nach dem Entfernen der Belagschicht 21 in jenen Bereichen, in welchen die Oberfläche dieser Schicht freigelegen hat, werden –

gegebenenfalls durch Plasmaätzen oder durch einen reaktiven Ätzvorgang - die erhabenen Gebiete und auch die eingesenkten Gebiete des Belages 21 freigelegt (Fig. 18). Hierauf kann dann noch das Substrat 20 unter Belassung eines Ringes im Randbereich des Belages 21 entfernt werden.

Der vorstehend beschriebene Herstellungsvorgang für die Transmissionsmaske kann auch dann durchgeführt werden, wenn der Belag 21 als ein auf das aus Silizium bestehende Substrat 20 abgeschiedener dünner Film aus beispielsweise Bornitrid oder Siliziumnitrid ist. Die Plasmaätzschritte (Fig. 13 und 17) werden dann in die jeweilige notwendige Tiefe des Films geführt. Als letzter Schritt wird dann das Substrat 2o bis auf einen peripheren Haltering weggeätzt.

0222738

Patentansprüche:

1. Verfahren zur Herstellung einer Transmissionsmaske zur Verwendung bei der Strukturierung von Substraten, insbes. von Halbleitersubstraten, bei der für ein Abbildungsmedium durchlässige Gebiete der Transmissionsmaske auf das Substrat abgebildet werden, wobei die für das Abbildungsmedium durchlässigen Gebiete der Transmissionsmaske eine Gitterstruktur mit gegenüber der Maskenfolie verstärkten Stegen aufweisen, dadurch gekennzeichnet, daß das Gitter regulär über die gesamte Maskenfläche abgebildet wird, daß das Gitter hierauf nur in den von den Öffnungen der abzubildenden Struktur eingenommenen Bereich in selbstjustierender (beliebiger) Dicke hergestellt wird, wobei gegebenenfalls Gitterstege den Rand der Struktur überdeckend ausgebildet werden.

2. Verfahren nach Anspruch 1, dadurch gekennzeichnet, daß auf ein Substrat, dessen Oberfläche für eine galvanische Abscheidung geeignet ist, z.B. einen Siliziumwafer oder eine Glasplatte mit metallischer Kontaktschicht an der Oberfläche, eine bevorzugt organische Resistschicht, z.B. in einer Dicke von 1,5 um aufgebracht wird, daß diese Resistschicht strukturiert wird, z.B. durch UV-Belichtung einer Photomaske und nachfolgender Entwicklung, durch Röntgen- oder Ionenstrahllithographie, bevorzugt scannende Elektronenstrahllithographie, daß auf die strukturfreien, seitlich von der Resistschicht begrenzten Bereiche des Substrates, galvanisch eine Maskenfolie, z.B. aus Nickel, bis zu einer gewählten Dicke aufgewachsen wird, bevorzugt bis zu einer Dicke, die geringer ist als die Resistdicke, daß auf die freie Oberfläche der galvanisch aufgewachsenen Maskenfolie, gegebenenfalls unter Freihalten eines Randstreifens zum angrenzenden Resist, eine elektrisch isolierende Schicht, z.B. aus Siliziummonoxid oder Magnesiumoxid, insbes. durch Aufdampfen oder Sputtern, aufgebracht wird, daß der Resist entfernt und solcherart Durchbrechungen in der galvanisch aufgewachsenen Maskenschicht geschaffen werden, die bis zum Substrat reichen, daß die Durchbrechungen in der Maskenfolie durch eine weitere Resistschichte gefüllt werden, die auf das Substrat aufgetragen wird, bis ihr Niveau über dem Substrat höher liegt als das Niveau der elektrisch isolierenden Schicht, daß die freie Oberfläche der das Substrat samt galvanisch aufgewachsener Maskenfolie und Isolierschicht bedeckenden Resistschicht mit einer regelmäßigen Gitterstruktur, z.B. durch Belichten und Entwickeln, versehen wird, daß die Resistschicht in den von den Gitterstegen eingenommenen Bereichen entfernt wird, daß das Substrat, samt der darauf befindlichen, mit der Isolierschicht bedeckten Maskenfolie und dem in Form einzelner Blöcke verbliebenen Resist einem (zweiten) Galvanikprozeß unterworfen wird, wobei zwischen den Blöcken eine metallische Schicht bis zu einer frei gewählten Dicke in jenen Bereichen aufgewachsen wird, deren Grund elektrisch leitend ist, die mit der Isolierschicht bedeckten Bereiche der Maskenfolie sowie die von den Blöcken eingenommenen Bereiche auf der Isolierschicht und auf der freien Oberfläche des Substrates im Bereich der Durchbrechungen der Maskenfolie jedoch frei von galvanisch aufgebautem Material bleiben, wobei das galvanische Aufwachsen des Materials solange fortgesetzt wird, bis die freie Oberfläche der aufgewachsenen Gitterstruktur höher liegt als die freie Oberfläche der Maskenfolie, bevorzugt bis die freie Oberfläche der Gitterstruktur das Niveau der freien Oberfläche der Resistblöcke erreicht, und daß schließlich die Resistblöcke, z.B. durch chemisches Ablösen oder durch Plasmaveraschen, entfernt werden, worauf die Maskenfolie samt Gitter vom Substrat getrennt wird, z.B. durch Ablösen vom Substrat oder durch Abätzen des Substrates in jenem Bereich, der von der Maskenfolie eingenommen wird, wobei das Substrat als ring- bzw. rahmenartige Haterung der Maskenfolie verbleibt.

3. Verfahren nach Anspruch 1 oder 2, dadurch gekennzeichnet, daß die Reststrukturen an ihrer freien Oberfläche breiter ausgeführt werden als in dem von der freien Oberfläche bis zum Substrat reichenden Bereich.

4. Verfahren nach Anspruch 1, dadurch gekennzeichnet, daß auf ein Substrat, z.B. einem Si-Wafer, in einer Schicht oder in mehreren Schichten aus voneinander verschiedenen Materialien ein Belag aufgebracht wird, der gegen Ätzlösungen widerstandsfähiger ist als das Material des Substrates, daß der Belag in Bereichen seiner Oberfläche mit einer Maskierung aus einem Resist abgedeckt wird, daß der Belag samt darauf befindlicher Maskierung reaktiv geätzt wird, um in den Bereichen, die nicht vom Resist bedeckt sind, Belagsmaterial zu entfernen und Einsenkungen zu bilden, deren Boden höher liegt als die Trennebene zwischen Belag und Substrat, daß der die Maskierung bildende Resist von den erhabenen Stellen des Belages entfernt wird und die Böden der Einsenkungen abgedeckt werden, z.B. mit einem Photolack oder einer aufgedampften Schicht, daß auf die freie Oberfläche der erhabenen Bereiche des Belages und die freie Oberfläche der Abdeckung der Böden der Einsenkungen eine weitere Maskierungsschicht aufgebracht und als Gitter strukturiert wird, daß die Belagschicht in jenen Bereichen, bevorzugt durch Ätzen, entfernt wird, in welchen die Oberfläche der Belagsschicht frei liegt und gegebenenfalls auch das Substrat ausgehend von den freigelegten Bereichen angeätzt wird, daß sodann, bevorzugt durch Plasmaätzen oder durch einen reaktiven Ätzvorgang die erhabenen Gebiete des Belages und auch die demgegenüber eingesenkten Gebiete des Belages freigelegt werden, worauf das Substrat gegebenenfalls unter Belassung eines Ringes im Randbereich der Belagsschicht entfernt wird.

5. Verfahren nach Anspruch 4, dadurch gekennzeichnet, daß die die Böden der Einsenkungen des Belages abdeckende Schicht auch die erhabenen Gebiete des Belages abdeckend aufgebracht wird und hernach die erhabenen Gebiete durch Abtragen der Schicht bis auf ein unter dem Niveau der erhabenen Gebiete gelegenes Niveau freigelegt werden, die Böden der Einsenkungen des Belages jedoch von der Schicht bedeckt belassen werden.

0222738

FIG.1

FIG.2

FIG.3

FIG.4

⟶ 3

⟵ 4

⟵ 2

⟵ 1

FIG.5

2

⟵ 5
⟵ 2
⟵ 6
⟵ 1

FIG.6

2

⟵ 5
⟵ 7
⟵ 6
⟵ 1

14    14    14

FIG.7

⟵ 7
⟵ 6
⟵ 1

FIG.8

FIG.9

FIG. 10

FIG.11

4/5

0222738

FIG.12

22

21

20

FIG.13

22
21
27

20

FIG.14

27

23
21

20

FIG.15

28
23
27
21

20

0222738

FIG.16

24
23
21

20

FIG.17

25

24
23
21

20

26

FIG.18

21

20

FIG.19

21